Europäisches Patentamt

European Patent Office

Office européen des brevets

(11) Numéro de publication: **0 261 043**
**A1**

## (12) DEMANDE DE BREVET EUROPEEN

(21) Numéro de dépôt: 87420241.9

(22) Date de dépôt: 18.09.87

(51) Int. Cl.⁴: **G 01 R 31/28**

(30) Priorité: 19.09.86 FR 8613304

(43) Date de publication de la demande:
23.03.88 Bulletin 88/12

(84) Etats contractants désignés:
AT BE CH DE ES FR GB GR IT LI LU NL SE

(71) Demandeur: **Société DRAXY (s.a.r.l.)**
**Rue du Rif Tronchard Le Fontanil Cornillon**
**F-38120 Saint Egreve (FR)**

(72) Inventeur: **Devigne, Yves**
**2 Avenue Albert 1er de Belgique**
**F-38000 Grenoble (FR)**

(74) Mandataire: **de Beaumont, Michel**
**1bis Rue Champollion**
**F-38000 Grenoble (FR)**

(54) **Testeur de circuits électroniques.**

(57) Un testeur de circuits électroniques selon l'invention comprend : une carte de connexion (24) pour raccordement à chacune des bornes du circuit à tester ; n cartes (16) dites broches électroniques comprenant des moyens de mise en forme de signaux dont chacune est connectée à une entrée de la carte de connexion ; un module unique de mémoire de vecteurs de test (17) contenant tous les vecteurs de test destinés au circuit et attendus de celui-ci, ces vecteurs transitant par lesdites broches électroniques ; un ordinateur central (10) pour gérer le système et assurer des liaisons externes. La gestion de la mémoire de vecteurs est assurée concurremment par une unité de gestion de mémoire (22) reliée indépendamment des autres modules du testeur à l'ordinateur central (10) et un processeur d'adresses (23) fonctionnant de façon asynchrone par rapport à l'ordinateur central.

Fig. 2

**Description**

## TESTEUR DE CIRCUITS ÉLECTRONIQUES

La présente invention concerne un testeur de circuits électroniques.

Dans le domaine de la fabrication et de l'utilisation des circuits intégrés, l'un des facteurs essentiels réside dans la qualité. Un circuit intégré, par exemple, étant généralement destiné à servir de coeur à des ensembles extrêmement complexes, il faut s'assurer initialement que ce circuit fonctionne dans toutes les configurations possibles et dans tous les cas logiques possibles. En effet, en utilisation, un défaut pourrait n'apparaître que très tardivement lors d'une situation spécifique. Un tel défaut pourrait alors être catastrophique si, par exemple, ce circuit intégré sert de coeur à un système militaire, médical ou industriel.

Ainsi, on a prévu des appareils dits testeurs destinés à vérifier le bon fonctionnement des circuits électroniques, et les circuits intégrés comprennent souvent des structures qui ne servent pas dans leur fonctionnement normal mais qui sont seulement destinées à faciliter les vérifications du bon fonctionnement du circuit.

Généralement, les testeurs sont des appareils utilisés d'une part par des fabricants de circuits intégrés ou de circuits électroniques complexes, d'autre part par les utilisateurs qui réeffectuent des tests sur chacun des circuits qu'ils ont acquis alors que, souvent, le fabricant ne fait de vérification approfondies que sur un échantillonnage des circuits qu'il fabrique et valide un lot dès qu'un certain pourcentage de circuits dans le lot s'avère totalement bon.

Dans tous les cas, il est souhaitable qu'un testeur présente les qualités suivantes :
- grande rapidité et précision de fonctionnement ; en effet, de nombreux tests doivent être réalisés sur des composants complexes et il est souhaitable que le temps élémentaire occupé par chacune des vérifications soit aussi court que possible ;
- simplicité de programmation et souplesse d'utilisation ;
- grande modularité, pour permettre avec un même testeur de tester des circuits différents en réduisant au maximum les changements à apporter au testeur.

Dans la présente demande, on s'intéressera aux testeurs permettant de vérifier le fonctionnement d'un circuit électronique au niveau de l'ensemble de ses broches et non pas aux testeurs à structures monobroches ou monovoie qui présentent certes des avantages de modularité mais qui présentent des inconvénients de coût, car si l'on veut tester plusieurs broches on est amené à dupliquer de nombreux circuits existant sur chaque voie, tels que le processeur de vecteurs de test, les circuits de génération de retard, les diverses références analogiques... . Du fait de ces duplications, ces testeurs présentent également l'inconvénient d'une non-reproductibilité des conditions de test d'une voie à une autre. D'autre part, dans ces structures, les vecteurs de test sont répartis bit par bit dans les mémoires des différentes voies et donc difficiles d'accès pour l'opérateur.

En ce qui concerne les opérations à effectuer, un testeur procède généralement et de façon successive à trois types de contrôles.

D'abord, un contrôle de vraisemblance, c'est-à-dire un contrôle assez grossier dans lequel on vérifie simplement si les diverses alimentations et les divers accès d'entrée/sortie ne sont pas en court-circuit ou en circuit ouvert.

Deuxièmement, un contrôle paramétrique dans lequel on vérifie au niveau de chaque entrée/sortie si son impédance est bien dans une plage acceptable pour les divers signaux. Dans ces deux premiers contrôles on est amené à mesurer des valeurs analogiques et on doit tenir compte des constantes de temps d'établissement. Chaque test individuel a typiquement une durée de quelques millisecondes. Sur un circuit intégré à 256 broches, on fera environ 500 tests pour le contrôle paramétrique.

Troisièmement, un contrôle fonctionnel où l'on vérifie si le fonctionnement du circuit est convenable. Pour cela, on envoie sur une ou plusieurs broches du circuit à tester des suites de signaux, dits vecteurs de test, mises en forme en durée et en amplitude et l'on vérifie au niveau d'une ou plusieurs autres broches si les signaux reçus en réponse correspondent bien à la fonction que l'on attend du circuit. Au niveau du contrôle fonctionnel, on vérifie également si le circuit logique a bien la rapidité qu'on en attend. Typiquement, un test fonctionnel élémentaire dure environ 100 ns et on procède à 4000 tests pour un circuit intégré à 256 broches.

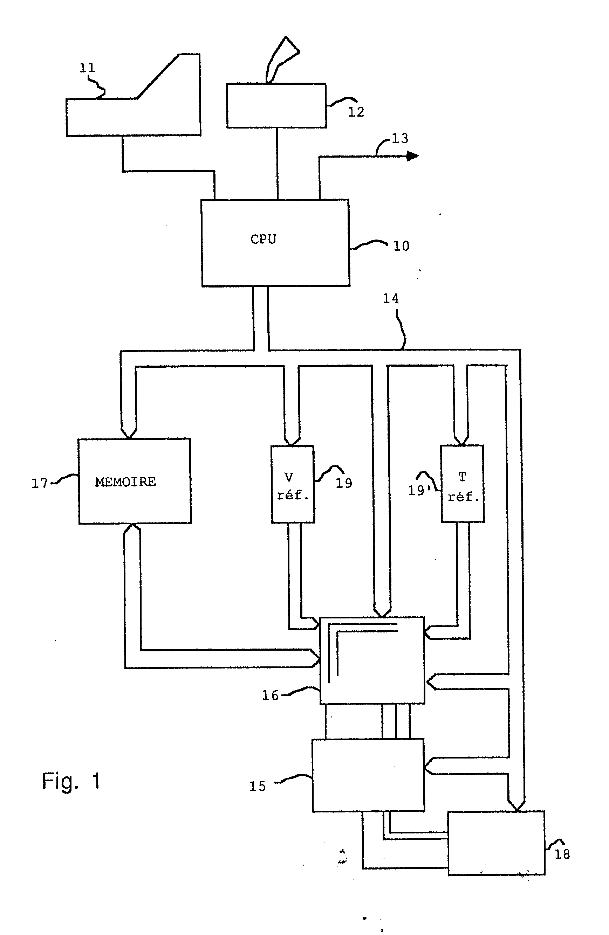

Un exemple de machine de test classique est représenté schématiquement en figure 1. Elle est basée sur un ordinateur central de grande capacité 10 connecté d'une part à des éléments externes tels qu'un terminal 11, une imprimante 12, et un accès 13 destiné à faire la liaison avec d'autres appareils, par exemple une ligne de communication vers un ordinateur hôte. D'autre part, l'unité centrale 10 est connectée à un bus 14 destiné à transmettre et à recevoir des données à partir des divers éléments du testeur.

Le circuit à tester est relié au testeur par l'intermédiaire d'une carte d'enfichage non représentée, puis d'une carte de charge 15 dont les conexions d'entrée/sortie correpondent au nombre de broches de l'élément à tester. Chacune de ces connexions est reliée à une carte particulière, dite broche électronique, 16 dont une seule est représentée en figure 1 et qui constitue en fait un empilement de cartes, généralement disposées géométriquement en anneau. Ces cartes 16 comprennent, d'une part, une liaison bidirectionnelle vers une mémoire de vecteurs de test 17 et une connexion personalisée vers une borne de la carte de charge 15 et, d'autre part, des accès à des circuits communs de fourniture de tensions de référence, 19, et de fourniture de durées de retard, 19', et au bus général 14. Chaque broche électronique 16 comprend des circuits de mise en forme temporelle et de mise à niveau pour ajuster les signaux reçus de la mémoire 17 aus référénces fournies par les circuits 19 et 19'. La carte de charge 15 comprend des impédances d'adaptation et des commutateurs pour relier les broches à tester ou bien à une broche électronique ou bien à une centrale de mesure 18 qui applique des courants et mesure des tensions ou inversement.

Chacun des éléments 15, 16, 17, 18, 19, 19' doit être programmé pour assurer un fonctionnement satisfaisant et est relié au bus commun 14 ; chacun de ces éléments, ou chacun des sous-éléments constituant chacun de ces éléments, est affecté d'une adresse spécifique permettant de reconnaître les signaux du bus qui lui sont adressés et peut inversement renvoyer sur le bus des signaux caractéristiques qui sont détectés par l'ordinateur 10.

Cette description d'un testeur de l'art antérieur est fort schématique mais est essentiellement destinée à représenter l'architecture d'ensemble d'un testeur classique basé sur un ordinateur central et un bus d'interconnexion commun avec des modules qui sont connectés en parallèle sur des adresses différentes et qui assurent chacun une des fonctions élémentaires du testeur.

Dans une telle structure, le fonctionnement des modules 15, 16, 18, 19, 19' et les opérations à effectuer sur ces modules sont de façon inhérente relativement lentes, par exemple de l'ordre de la milliseconde ou du dixième de milliseconde. Par contre, la mémoire 17, qui contient les vecteurs de test que l'on veut envoyer vers le circuit à tester et ceux que l'on en reçoit, doit pouvoir se vider et se remplir à un rythme très rapide, couramment de l'ordre de la dizaine de nanosecondes. En effet, on doit pouvoir atteindre des vitesses correspondant aux vitesses maximales pour lesquelles le circuit à tester a été conçu afin de vérifier son fonctionnement à haute fréquence. Ainsi, l'ordinateur central 10 doit gérer de façon extrêmement rapide la mémoire de vecteurs de test 17 par l'intermédiaire du bus 14. Cette mémoire 17 est une mémoire de très forte capacité, par exemple plusieurs Moctets. En conséquence, dans les testeurs de l'art antérieur, on a utilisé divers moyens sophistiqués pour augmenter au maximum cette vitesse de gestion mais ceci amène à des solutions techniques relativement complexes car le bus 14 se trouve extrêmement chargé du fait de ses multiples connexions à plusieurs modules et en conséquence sa vitesse de transmission est a priori limitée.

Par ailleurs le fait de prévoir un circuit centralisé 19' transmettant à de nombreuses cartes (broches électroniques) des signaux temporels pour imposer des références de phase entraine que ces références de phase sont inévitablement entachées d'erreurs systématiques, différentes pour les différentes broches, par suite des retards apportés par les longueurs de fils qui ne peuvent être négligeables dans des circuits aussi complexes.

Ainsi, un objet de la présente invention est de prévoir un testeur dont l'architecture générale permet une augmentation de la vitesse de gestion de la mémoire de vecteurs de test.

Un autre objet de la présente invention est de prévoir un testeur dans lequel la liaison entre le circuit à tester et les parties logiques du testeur est améliorée pour permettre une plus grande modularité.

Un autre objet de la présente invention est de prévoir un testeur permettant d'obtenir des références de phase temporelles bien déterminées.

Ces objets de la présente invention sont atteints en prévoyant un testeur de circuits électroniques comprenant : une carte de connexion pour raccordement à chacune des bornes du circuit à tester ; n cartes dites broches électroniques comprenant des moyens de mise en forme de signaux dont chacune est connectée à une entrée de la carte de connexion ; un module unique de mémoire de vecteurs de test contenant tous les vecteurs de test destinés au circuit et attendus de celui-ci, ces vecteurs transitant par lesdites broches électroniques ; un ordinateur central pour gérer le système et assurer des liaisons externes ; dans lequel la gestion de la mémoire de vecteurs est assurée concurremment par une unité de gestion de mémoire reliée indépendamment des autres modules du testeur à l'ordinateur central et un processeur d'adresses fonctionnant de façon asynchrone par rapport à l'ordinateur cental.

Selon un mode de réalisation, ce testeur comprend en outre une centrale de mesure analogique, dans lequel chaque broche électronique comprend sur une même carte : un circuit de bascules programmable pour synchroniser et conférer une retard prédéterminé aux vecteurs de test transmis par cette broche électronique, un circuit fournissant ledit retard, des circuits de mise à niveau programmables et, un circuit de multiplexage permettant de connecter le circuit à tester ou bien aux circuits susmentionnés ou bien à la centrale de mesure analogique.

Le fait que la mémoire de vecteurs de test soit couplée à son propre processeur d'adresses et à son propre circuit de gestion de mémoire permet un fonctionnement très rapide indépendamment du bus général de l'ordinateur central.

Le fait que les références de retard aient été incorporées dans les broches électroniques permet d'obtenir des références temporelles très précises et spécifiques à chaque broche électronique.

Le choix des éléments montés sur chaque broche électronique permet d'obtenir une très grande modularité.

Ces objets, caractéristiques et avantages ainsi que d'autres de la présente invention seront exposés plus en détail dans la description suivante d'un mode réalisation particulier faite en relation avec les figures jointes parmi lesquelles :

　　la figure 1 représente une architecture de testeur de l'art antérieur ;

　　la figure 2 représente une architecture de testeur selon la présente invention ;

　　la figure 3 représente un autre aspect de l'architecture de testeur selon la présente invention ; et

　　la figure 4 représente sous forme de blocs une broche électronique selon la présente invention et fait mieux voir les deux directions de transfert possibles dans une broche électronique donnée.

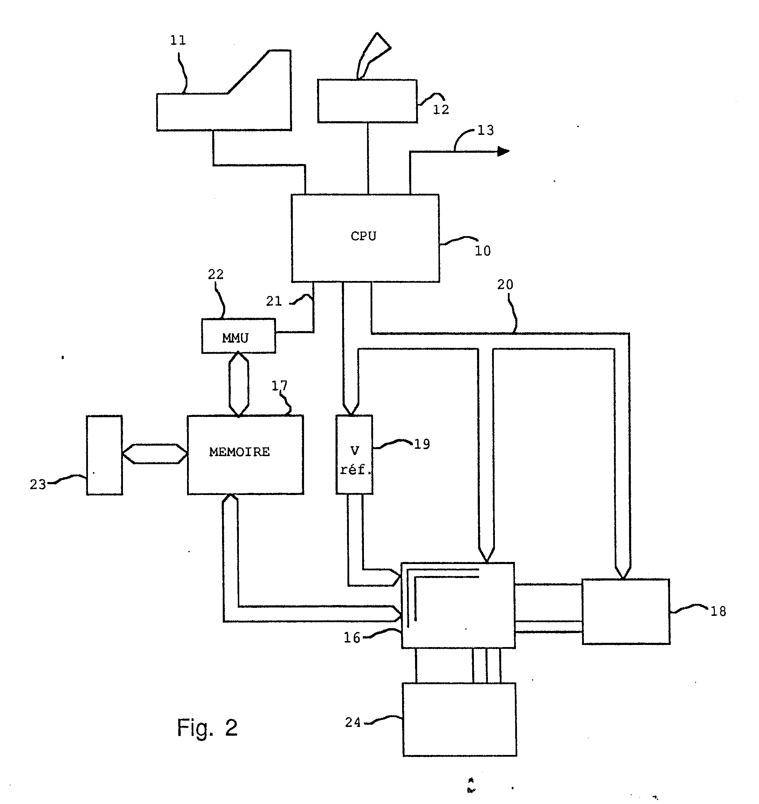

La figure 2 représente l'architecture générale d'un testeur selon la présente invention présentée de façon aussi analogue que possible à l'illustration de la figure 1 pour mieux faire ressortir les différences entre l'architecture selon la présente invention et les architectures classiques de l'art antérieur.

On retrouve en figure 2 l'ordinateur central 10, le terminal 11, l'imprimante 12 et le bus de communication 13. Toutefois, la liaison entre l'ordinateur central 10 et les divers modules du testeur est différente. Dans un premier temps, dans cette figure, on a représenté ces modules de façon similaire au cas de la figure 1 pour faciliter la comparaison mais on verra ci-après que l'organisation elle-même de ces modules peut être distincte. Ainsi, on retrouve en figure 2 la mémoire de vecteurs de test 17, les broches électroniques 16 et la centrale de mesure 18. Un bus commun 20 est toujours utilisé, mais pour effectuer les seules opérations "lentes", dites de configuration, à l'exclusion de la gestion directe de la mémoire de vecteurs de test.

L'ordinateur 10 ne communique plus directement avec la mémoire 17 mais, par l'intermédiaire d'une liaison 21 telle qu'une liaison série RS 232C, avec un module particulier de gestion de mémoire 22 (couramment désigné dans la technique par le sigle MMU d'après l'appellation anglo-saxonne Memory Management Unit). Il est en outre prévu un processeur d'adresses spécialisé 23 permettant d'effectuer des séquences particulières d'adressage programmables dans la mémoire. Tous ces circuits sont commercialement disponibles. Par exemple, pour le MMU 22 on pourra choisir un circuit Motorola M6809 et pour le processeur d'adresses un circuit de la Société AMD dit AM 2910 qui permet d'atteindre des cadences d'adressage très élevées, pouvant dépasser 10 MHz. Ce processeur est associé à une horloge à fréquence variable pour permettre, dans certains ces, de modifier la cadence des séquences de test.

Le plan mémoire où sont stockés les vecteurs de test est donc partageable entre le MMU 22 qui permet de lire et d'écrire classiquement dans la mémoire à des fins d'observation ou de chargement et le processeur 23 qui permet un adressage de la mémoire pour émettre les vecteurs de test à un rythme rapide choisi en fonction des exigences du test.

Outre cette modification générale architecturale, la présente invention prévoit une configuration et un groupement particuliers des diverses fonctions sur les cartes constituant le système.

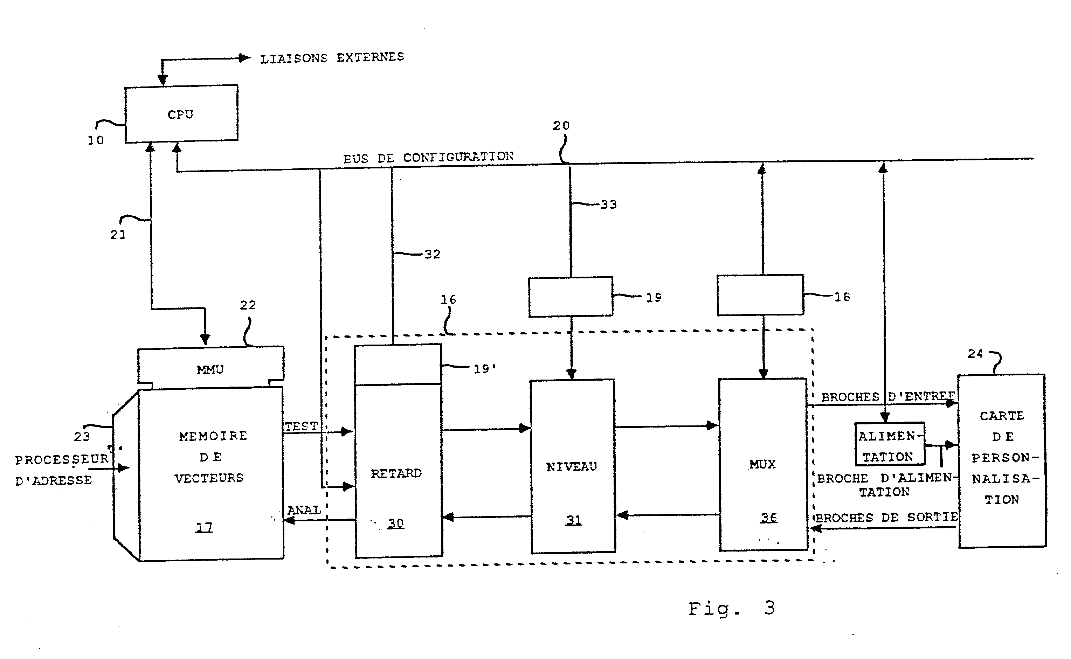

Cette configuration particulière qui sera détaillée en relation avec la figure 3 apparaît déjà en figure 2. Le bloc 19' fournissant les valeurs de retard temporel pour chaque broche n'apparaît plus. En effet il est incorporé dans la broche électronique 16. De même la broche électronique n'est plus associée à une carte de charge 15 mais à une carte de personnalisation 24. Cette carte de personnalisation 24 ne comprend plus de commutateurs actifs programmables qui sont maintenant reportés dans la broche électronique, mais seulement des éléments de connectique permettant de relier électro-mécaniquement les broches du circuit à tester à la broche électronique 16. En conséquence la centrale de mesure 18 est directement reliée aux broches électroniques.

La figure 3 représente de façon fonctionnelle l'association des modules du système. On y retrouve, avec un symbolisme différent de celui de la figure 2 mais de mêmes références numériques, l'ordinateur central CPU 10, le bus 20 appelé bus de configuration, la liaison 21 avec le MMU 22, le processeur d'adresses 23 et la mémoire de vecteurs 17. La mémoire de vecteurs est organisée en canaux dont chacun est connecté à une broche électronique 16 particulière. Chaque broche électronique 16 comprend notamment : des moyens 30 pour assurer une synchronisation et un réglage en retard, des moyens 31 pour assurer un réglage en niveau des vecteurs de test émis et reçus, et un multiplexeur 36. La liaison entre la mémoire de vecteurs de test 17 et la carte 16 se fait dans une direction pour émettre des signaux de vecteurs de test (TEST) et, dans l'autre direction, pour recevoir en retour des vecteurs de test d'analyse (ANAL) qui sont prélevés sur le circuit à contrôler et transmis à la mémoire de vecteurs pour y être comparés à une réponse attendue ou y être stockés.

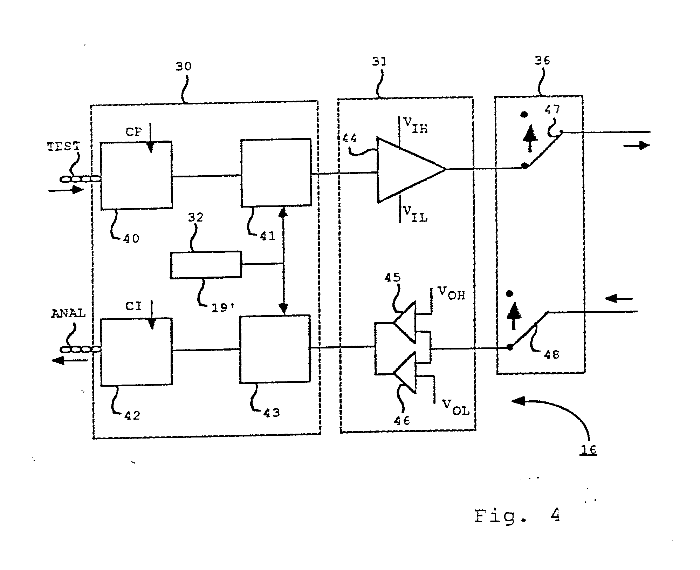

Les circuits 30 de réglage en retard comprennent essentiellement une paire de bascules, 40, 41 sur la voie TEST, et 42, 43 sur la voie ANAL (figure 4). Les premières bascules 40, 42 assurent la synchronisation avec l'horloge C1 du processeur d'adresses 23. Les deuxièmes bascules, 41, 43 reçoivent une entrée d'un circuit de retard 19' programmable sous l'effet d'une commande 32 en provenance du bus de configuration 20. Elles permettent d'imposer un retard donné sur les signaux transmis par la mémoire de vecteurs et ceux réémis par la broche électronique par rapport à l'horloge de cadencement C1 du processeur d'adresses 23.

On notera que le fait de prévoir un circuit de retard programmable par broche électronique ne conduit pas à un système plus complexe que la disposition de l'art antérieur où les références de retard étaient distribuées à partir d'un circuit 19' unique car :
- ces circuits de retard sont en pratique relativement simples,
- l'emploi d'un circuit centralisé obligeait à utiliser un système de multiplexage à haute vitesse sur chaque broche électronique et ce circuit était en fait encore plus difficile à réaliser que les circuits de retard.

Grâce à l'agencement selon l'invention, on évite les retards parasites liés aus lignes de transmission et à la disparité des composants intermédiaires (multiplexeurs, ...) et on améliore la souplesse de programmation.

Le circuit de réglage en niveau 31, comprend des réseaux d'impédances, réalisés classiquement à l'aide de transistors, et reçoit ses alimentations du module de référence de niveau 19 programmable sous l'effet d'une commande 33 en provenance du bus de configuration 20.

Ce circuit 31 permet de transformer les signaux logiques en provenance de la mémoire de test en créneaux de tension variant entre des niveaux haut et bas déterminés en accord avec le circuit de référence du niveau 19. Inversement ce circuit 31 comprend une voie de retour transformant en signaux logiques les tensions reçues de la broche testée par comparaison à des valeurs de références programmées par le circuit 19.

Le multiplexeur 36 permet de commuter la broche du circuit à tester soit aux circuits de la broche électronique soit à la centrale de mesure 18.

Dans le cas où l'on est dans une phase de contrôle fonctionnel, chaque broche électronique 16 est directement couplée à la carte de personnalisation 24. La carte de personnalisation 24 selon l'invention comprend une connectique permettant de se relier à un circuit à tester.

Enfin, pour les contrôles initiaux à savoir les contrôles de vraisemblance et les contrôles paramétriques, le multiplexeur 36 renvoie les sorties de la carte de personnalisation vers la centrale de mesure 18. Ces traitements de mesure de courant et de tension se faisant de façon analogique, il conviendra de prévoir des convertisseurs numérique/analogique et analogique/numérique dans la centrale de mesure 18 pour communiquer avec le bus 20.

La figure 4 reprend sous une forme un peu plus détaillée les principaux éléments de la broche électronique 16 en séparant les sens de transmission. Le bloc 30 de synchronisation et de réglage de retard a été décrit précédemment. Le bloc 31 comprend dans le sens TEST un amplificateur opérationnel 44 fixant les niveaux d'entrée haut et bas $V_{IH}$ et $V_{IL}$ selon les valeurs transmises par le bloc 19 qui fournit également des niveaux de comparaison haut et bas $V_{OH}$ et $V_{OL}$ à des comparateurs 45 et 46 analysant les signaux renvoyés par le circuit à tester. Le mulitplexeur 36 peut être symbolisé par des commutateurs à deux voies 47 et 48 reliant la carte de personnalisation aux autres circuits de la broche électronique ou à la centrale de mesure 18.

Un avantage supplémentaire de l'invention est qu'elle permet de fabriquer un testeur de faible coût d'exploitation pour l'utilisateur. Ceci est notamment dû au fait que le multiplexeur 36 est réparti sur les broches électroniques alors qu'il était classiquement prévu sur une carte de charge 15. La carte de charge était donc une carte coûteuse, ces multiplexeurs incorporant de nombreux relais, et l'utilisateur était amené à utiliser une carte de charge spécifique pour chaque famille de circuits à tester. Selon l'invention il doit seulement changer les cartes de personnalisation qui ne comprennent aucun élément dispendieux si ce n'est des connecteurs. En outre, du fait de leur simplicité et de leur spécialisation, les cartes de personnalisation associées à l'architecture de testeur selon l'invention peuvent s'adapter à de nombreux circuits pour autant qu'ils soient mécaniquement compatibles du point de vue de leur brochage.

## Revendications

1. Testeur de circuits électroniques comprenant :
- une carte de connexion (34) pour raccordement à chacune des bornes du circuit à tester ;
- n cartes (16) dites broches électroniques comprenant des moyens de mise en forme de signaux dont chacune est connectée à une entrée de la carte de connexion ;
- un module unique de mémoire de vecteurs de test (17) contenant tous les vecteurs de test destinés au circuit et attendus de celui-ci, ces vecteurs transistant par lesdites broches électroniques ;
- un ordinateur central (10) pour gérer le système et assurer des liaisons externes ;
caractérisé en ce que la gestion de la mémoire de vecteurs est assurée concurremment par une unité de gestion de mémoire (22) reliée indépendamment des autres modules du testeur à l'ordinateur central (10) et un processeur d'adresses (23) fonctionnant de façon asynchrone par rapport à l'ordinateur central.

2. Testeur selon la revendication 1, comprenant en outre une centrale de mesure analogique (18), caractérisé en ce que chaque broche électronique (16) comprend sur une même carte :
- un circuit de bascules programmable (30 ; 41-43) pour synchroniser et conférer une retard prédéterminé aux vecteurs de test transmis par cette broche électronique,
- un circuit (19') fournissant ledit retard,
- des circuits de mise à niveau (31) programmables, et
- un circuit de multiplexage (36) permettant de connecter le circuit à tester ou bien aux circuits susmentionnés ou bien à la centrale de mesure analogique (18).

0261043

Fig. 1

0261043

Fig. 2

LIAISONS EXTERNES

CPU

10

21

EUS DE CONFIGURATION

20

33

32

22

MMU

16

19'

19

18

PROCESSEUR
D'ADRESSE

23

MEMOIRE
D E
VECTEURS

17

TEST

ANAL

RETARD

30

NIVEAU

31

MUX

36

BROCHES D'ENTREE

ALIMEN-
TATION

BROCHE D'ALIMEN-
TATION

BROCHES DE SORTIE

24

CARTE
D E
PERSON-
NALISA-
TION

0261043

Fig. 3

Fig. 4

0261043

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| A | WESCON TECHNICAL PAPERS, vol. 19, 16-19 septembre 1975, pages 27/2(1)-27/2(4), San Francisco, US; J.F. CAMPBELL, Jr.: "A new real-time funtion test generation system for complex LSI testing" * Page 27/2(2), colonne 1, lignes 18-50; page 27/2(4), colonne 1, lignes 26-42 * | 1 | G 01 R 31/28 |
| | --- | | |
| A | ELECTRONIC ENGINEERING, vol. 57, no. 707, novembre 1985, pages 153,156,157,159,161,162,165, Londres, GB; M. HAY: "A second generation performance tester" * Page 153, colonne 3, ligne 34 - page 156, colonne 1, ligne 8; page 157, colonne 3, lignes 12-25 * | 1,2 | |
| | | | DOMAINES TECHNIQUES RECHERCHES (Int. Cl.4) |
| | --- | | G 01 R 31/28 |
| A | IBM TECHNICAL DISCLOSURE BULLETIN, vol. 25, no. 9, février 1983, pages 4872-4876, New York, US; T.V. LANDON et al.: "High speed hardware-based diagnostic system for high speed digital subsystems" * Page 4874, ligne 5 - page 4875, ligne 6 * | 1 | G 06 F 11/26 |
| | --- | | |
| A | FR-A-2 543 709 (CENTRE NATIONAL DE LA RECHERCHE SCIENTIFIQUE) | | |
| | ----- | | |

Le présent rapport de recherche a été établi pour toutes les revendications

| Lieu de la recherche | Date d'achèvement de la recherche | Examinateur |
|---|---|---|
| LA HAYE | 06-11-1987 | HERREMAN,G.L.O. |